# FASCICULE DE BREVET EUROPEEN

(11) **EP 0 316 211 B1**
(45) Date de publication et mention de la délivrance du brevet: **19.07.2000**
(21) Numéro de dépôt: 88402730.1
(22) Date de dépôt: 28.10.1988
(51) Int. Cl.: H01L 27/02, H01L 29/72

(54) **Circuit intégré protégé contre des décharges électrostatiques, avec seuil de protection variable**
Gegen elektrostatische Entladungen geschützter integrierter Schaltkreis mit variablem Schutzschwellwert
Integrated circuit protected against electrostatic discharges, with a variable protection threshold

(30) Priorité: 06.11.1987 FR 8715405
(43) Date de publication de la demande: 17.05.1989
(73) Titulaire: STMicroelectronics S.A., 94250 Gentilly (FR)
(72) Inventeur: Kowalski, Jacek, F-75116 Paris (FR); Tailliet, François, F-75116 Paris (FR)
(74) Mandataire: Ballot, Paul Denis Jacques

(56) Documents cités:
- EP-A- 0 032 018
- US-A- 4 408 245
- IBM TECHNICAL DISCLOSURE BULLETIN, vol. 23, no. 2, juillet 1980, pages 594-595, New York, US; D.C. BANKER et al.: "Lateral NPN protect device"
- IBM TECHNICAL DISCLOSURE BULLETIN, vol. 27, no. 11, avril 1985, pages 6814-6815, New York, US; "Protective device"

## Description

La présente invention concerne les circuits intégrés réalisés en technologie MOS (Métal- Oxyde- Semiconducteur), et plus généralement les circuits intégrés qui sont sensibles aux risques de malfonctionnement ou de destruction en présence de décharges électrostatiques.

Les décharges électrostatiques peuvent se produire parfois tout simplement parce qu'un utilisateur touche les bornes d'entrée-sortie des circuits intégrés. Ce risque deviendra de plus en plus fréquent à mesure que l'usage de circuits intégrés se répandra dans le public, par exemple sous forme de cartes à puces qui seront beaucoup manipulées et dans lequelles les bornes de sortie sont directement accessibles sans protection.

Pour protéger les circuits intégrés contre ces risques, il est maintenant classique de prévoir, entre chacune des bornes de signal et une borne de masse commune, un élement intégré dans le circuit, élément qui a pour fonction de devenir brusquement conducteur lorsqu'une surtension dépassant un seuil prédéterminé se présente entre ses bornes; cet élément a bien entendu des capacités d'absorption d'énergie ou de courant supérieures à celles des autres éléments du circuit intégré, et d'autre part il est conçu pour devenir conducteur plus rapidement que les éléments à protéger dans le circuit intégré.

Classiquement, l'élément de protection est une diode dont l'anode est reliée à la borne de masse et la cathode est reliée à la borne de masse et la cathode est reliée à une autre borne d'entrée-sortie (ceci bien entendu en supposant que la borne de masse est une borne d'alimentation négative).

Les documents US-A-4 408 245 et IBM TDB vol. 23 n° 2, juillet 1980, p. 594 décrivent une telle diode avec une grille pour protéger une borne d'alimentation contre les surtensions.

Cette diode reste normalement bloquée tant que la tension sur la borne à protéger ne dépasse pas un seuil de mise en avalanche. Si le seuil est dépassé, elle passe en avalanche et absorbe le courant de décharge électrostatique. il faut qu'elle passe en avalanche avant les autres jonctions présentes dans le circuit intégré et soumises à la même surtension. Or la tension de déclenchement du processus d'avalanche est essentiellement liée à des paramètres technologiques tels que le dopage du substrat semiconducteur dans lesquel est formé le circuit, et le dopage des diverses régions diffusées dans ce substrat.

Il est difficile de bien maîtriser la connaissance des tensions d'avalanche des jonctions à protéger et de maîtriser la réalisations d'une diode de protections qui aurait une tension d'avalanche inférieure à celle des jonctions à protéger tout en restant supérieure aux tensions normales de fonctionnement du circuit; il serait en effet inacceptable que l'élément de protection passe en état de conduction simplement parce qu'un signal de relativement grande amplitude (mais qui n'est pas une décharge dangereuse) se présente sur une borne du circuit.

Or, les spécifications de tenue en tension des circuits intégrés sont relativement sévères et sont finalement assez proches des tensions qui risqueraient d'endommager ou détruire le circuit. Par exemple, les spécifications peuvent exiger que le circuit fonctionne normalement s'il reçoit des signaux ou des tensions d'alimentation pouvant aller jusqu'à 15 volts, alors que le seuil de destruction serait de 22 volts. on a donc la nécéssité de prévoir que l'élément de protection se déclenche à partir d'une tentions largement inférieure à 22 volts (si elle est trop près de 22 volts il subsiste un risque de destruction par dcéclenchement insuffisamment rapide de la conduction); mais il faut aussi que l'élément de protection se déclenche pour une tension suffisamment supérieure à 15 volts (faute de quoi il y a risque de déclenchements intempestifs au dessous de 15 volts).

La marge de choix de la tension d'avalanche est donc étroite et elle est d'autant plus réduite que les dispersions technologiques sont plus grandes c'est-à-dire que les dimensions, concentrations, profondeurs de jonctions, et d'autres paramètres sont moins bien contrôlés dans le processus de fabrication.

Pour parvenir à une protection aussi efficace que possible des circuits intégrés, tout en autorisant des tensions de fonctionnement normal aussi élevées que possible, la présente invention propose une nouvelle solution qui part de la remarque que le front de montée des surtensions provenant de décharges électrostatiques (ou de la plupart des surtensions susceptibles de se présenter et d'endommager les circuits) est beaucoup plus raide que le front de montée des tensions normales (éventuellement relativement élevées) se présentant sur les bornes d'entrée-sortie du circuit.

En effet, ces tensions normales sont soit des tensions d'alimentation qui peuvent excéder la valeur prévue par les spécifications mais qui n'ont pas de raison ou pas de possibilité de varier très brutalement, soit des signaux logiques d'entrée-sortie qui, de manière exceptionnelle, passeraient à une valeur supérieure au maximum autorisé par les spécifications. les fronts de montée des signaux logiques n'excèdent pas quelques volts par nanoseconde, alors que les fronts de montée des décharges électrostatiques sont plutôt de quelques centaines de volts par nanoseconde.

Selon l'invention, on propose de connecter entre deux bornes du circuit intégré une diode associée à un moyen de modification de la répartition des équipotentielles à l'endroit de déclenchement de la conduction en avalanche de la diode, ce moyen étant sensible à la pente de croissance des surtensions se présentant sur cette borne de telle sorte que la tension de déclenchement d'avalanche soit plus faible lorsque la pente est plus raide que lorsqu'elle est moins raide.

Le moyen de modification de la répartition des équipotentielles est de préférence une grille isolée entourant toute une région diffusée constituant la cathode (ou l'anode) de la diode, et située à proximité immédiate de cette région.

Cette grille est reliée à la borne à protéger par un circuit intégrateur introduisant une constante de temps de telle sorte qu'une surtension à front raide arrivant sur cette borne soit transmise avec un léger retard à la grille.

Par exemple, la grille est reliée d'une part à une extrémité d'une résistance dont l'autre extrémité est reliée à la région diffusée et à la borne à protéger, et d'autre part à une extrémité d'une capacité dont l'autre extrémité est reliée à l'autre borne de la diode.

En pratique, la capacité n'a pas besoin d'être matérialisée par un élément de circuit bien identifié car les capacités de jonction de la résistance (réalisée par une région diffusée dans le substrat) et la capacité entre la grille et le substrat semi-conducteur dans lequel est diffusée la cathode de la diode sont duffisamment élevées pour jouer le rôle qu'on en attend, c'est à dire pour faire en sorte de retarder l'arrivée d'un front de tension sur la grille, ce retard induisant une différence de potentiel, entre région diffusée et grille, d'autant plus importante que le front est plus raide.

D'autres caractéristiques et avantages de l'invention apparaîtront à la lecture de la description détaillée qui suit et qui est faite en référence aux dessins annexés dans lesquels :
- la figure 1 représente schématiquement un circuit intégré dont une borne d'entrée est protégée par un élément de protection,
- la figure 2 représente symboliquement le dispositif de protection selon l'invention,
- la figure 3 représente, en coupe latérale selon la ligne AA de la figure 4, une structure possible pour l'élément de protection selon l'invention,
- la figure 4 représente, une vue de dessus de la structure de la figure 3, montrant également la constitution de la résistance d'intégration de la figure 2.

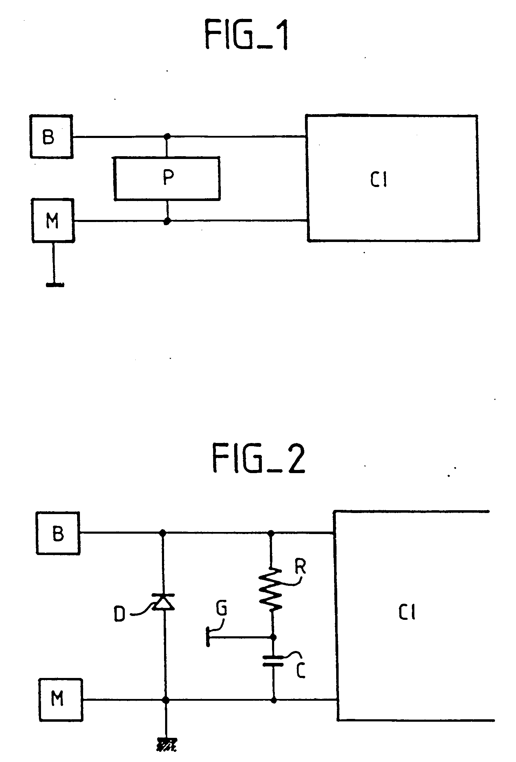

Sur la figure 1 on a représenté schématiquement un circuit intégré CI avec deux bornes d'entrée-sortie M et B; le circuit peut comporter bien entendu d'autres bornes, qui n'ont pas été représentées.

La borne M est une borne de référence de potentiel; c'est la borne la plus négative ou la plus positive du circuit; dans l'exemple qui sera décrit dans la suite, c'est la borne la plus négative, ce qui veut dire qu'en fonctionnement normal la tension sur la borne B ne descend jamais au dessous du potentiel de la borne M.

La borne B est une borne d'entrée/sortie à protéger; elle peut être une borne de signal recevant ou fournissant des signaux logiques, ou encore une borne d'alimentation positive.

D'une manière classique on prévoit un élément de protection P entre les bornes B et M; cet élément se comporte comme une impédance pratiquement infinie tant que la différence de potentiel entre les bornes B et M ne dépasse pas un seuil Vs, puis comme un limiteur de tension, avec une capacité importante d'absorbtion de courant lorsque ce seuil est dépassé.

L'invention porte sur la constitution de l'élément de protection.

Sur la figure 2, on a représenté schématiquement, sous forme symbolique, le principe de fonctionnement de l'élément de protection selon l'invention, placé entre les bornes B et M du circuit intégré.

L'élément de protection comporte en premier lieu une diode D dont l'anode est reliée à la borne M et la cathode à la borne B. Cette diode est normalement polarisée en inverse puisque, comme on l'a dit, les potentiels présents sur la borne B sont supérieurs au potentiel de référence de la borne M. De toute façon, si le potentiel de la borne B descendait de 0,6 volts environ au dessous du potentiel de référence, la diode se mettrait à conduire, empêchant que cette descente se poursuive.

Lorsque le potentiel de la borne B devient fortement positif et dépasse un certain seuil Vs, la diode D polarisée en inverse passe en état d'évalanche et se met à conduire.

Sur la figure 2 on a représenté symboliquement, sous forme d'une grille G à proximité de la jonction de la diode D, un moyen pour faire varier le seuil de tension Vs pour lequel la diode D passe en régime d'avalanche. L'application sur la grille G d'un potentiel Vg variable a pour effet de modifier le seuil Vs.

Plus précisément, en fonction du but que l'on cherche à atteindre selon l'invention, qui est d'augmenter Vs si les surtensions sont simplement des signaux "normaux" de niveau un peut trop élevé, et de diminuer Vs si les surtensions sont d'origine electrostatique, on connecte la grille G à la borne B par l'intermédiaire d'un circuit intégrateur, de telle manière que le potentiel Vg suive le potentiel de la borne B avec un certain retard. Ce circuit agit de manière que le potentiel Vg reste d'autant plus proche du potentiel de la borne B que le temps de montée des surtensions appliquées à la borne B est plus lent pendant la montée du signal.

Le circuit intégrateur est représenté sous la forme d'une résistance R et d'une capacité C; la résistance R est connectée entre la grille et la borne B; la capacité C est connectée entre la grille G et la masse M.

La grille est placée à proximité de la jonction de la diode D de telle sorte qu'elle ait une influence sur la répartition des lignes équipotentielles à l'intérieur des régions d'anode et de cathode de la diode, cette influence étant dans le sens suivant: les lignes équipotentielles sont plus courbées et plus resserées dans la région de claquage de la diode (celle où se déclenche initialement le régime d'avalanche) lorsque le potentiel Vg est plus faible; elles sont moins courbées et plus espacées lorsque le potentiel Vg est plus élevé.

Il résulte de celà que le claquage se produit pour une tension Vs1 plus élevée lorsque se présente une surtension avec un front de montée relativement lent, et pour une tension Vs2 moins élevée lorsque se présente une surtension avec un front de montée trés raide. Dans les deux cas, le potentiel de grille Vg et le potentiel de la surtension sur la borne B montent et les lignes équipotentielles augmentent leur courbure et se resserrent au fur et à mesure de cette montée. Mais dans le deuxième cas, le potentiel de grille Vg n'arrive pas à suivre le potentiel sur la borne B et la courbure des lignes équipotentielles est encore plus forte et leur resserrement encore plus grand que dans le premier cas pendant le front de montée; il en résulte que le seuil de passage en avalanche est nettement plus bas dans le cas d'un front de montée très raide.

Dans un exemple numérique illustratif, on peut montrer qu'avec une résistance de 2 kilohms et une capacité de O,1 picofarad, le potentiel Vg suivra le potentiel de la borne B avec un écart d'environ 1 volt pour des fronts de montée de l'ordre de 5 volts par nanoseconde (valeur courante pour de signaux logiques), et un écart atteignant très rapidement 40 volts pour des fronts de montée de 200 volts par nanoseconde (valeur courante pour des décharges électrostatiques). Cette différence entre les deux cas est largement suffisante pour modifier sensiblement le seuil de tension d'avalanche de la diode.

La mise en oeuvre de l'invention peut se faire en particulier avec un diode à jonction diffusée affleurant sur la surface d'un substrat semi-conducteur, l'affleurement de la jonction étant entouré ou recouvert d'une grille conductrice isolée venant à proximité immédiate de la jonction sur toute la périphérie de celle-ci.

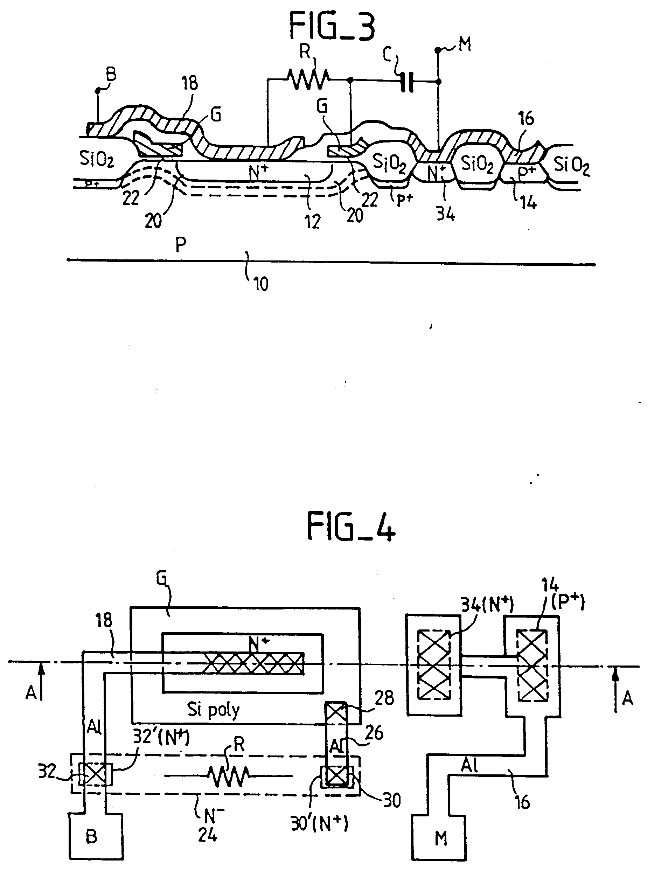

La figure 3 représente une coupe latérale d'une telle structure, et la figure 4 en représente une vue de dessus; la coupe est faite selon la ligne AA de la figure 4. Sur la figure 4, les croix représentent les zones de contact entre une métallisation conductrice et une région sous-jacente.

La diode D est constituée par une région de type N+ 12 diffusée superficiellement dans un substrat semi-conducteur 10 de type P.

Le substrat est relié à la masse M soit par sa face arrière, soit par l'intermédiaire d'une région 14 de type P+ diffusée localement à la surface du substrat et recouverte d'une métallisation 16 qui la relie à la borne M.

La région 12 est reliée à la borne B par une métallisation 18.

La région 12 est réalisée par diffusion locale d'impuretés de type N+ à partir de la surface du substrat. La jonction entre la région 12 et le substrat 10 présente donc comme celà est bien connu une courbure 20 le long de sa périphérie, là où elle remonte vers la surface supérieure du substrat.

On sait que c'est dans la région de cette courbure 20 que se déclenche initialement le régime d'avalanche lorsque la diode est soumise à une forte tension inverse. la raison en est que les lignes équipotentielles sont fortement courbées et resserrées au voisinage de cette courbure.

Parfois aussi le régime d'avalanche se déclenche dans la zone où la jonction affleure à la surface du substrat, soit parce que les dopages sont plus élevés en surface, soit par suite de défauts pouvant exister à l'affleurement de la jonction. Dans ce cas aussi, le claquage se produit dans les zones où le champ électrique est le plus élevé par rapport à l'aptitude de ces zones à supporter ce champ électrique, et par conséquent encore dans les zones où les équipotentielles sont les plus resserrées.

La périphérie de la région diffusée 12 est complètement entourée d'une grille G en silicium polycristallin, recouvrant l'affleurement de la jonction et isolée de la surface de substrat par une couche isolante mince 22 (oxyde de silicium). Cette grille G est réalisée selon le même processus que les grilles des transistors MOS du circuit intégré et, de même que les grilles des transistors MOS débordent légèrement au dessus des régions de source et de drain, de même la grille G recouvre l'affleurement de la jonction en débordant très légèrement sur tout la périphérie de la région 12.

Plus le potentiel appliqué à la grille G est positif, plus les lignes équipotentielles au voisinage de la courbure de jonction 20 et de l'affleurement de la jonction se desserrent, et donc plus la tension Vs qu'il est nécéssaire d'appliquer aux bornes de la diode D pour la mettre en régime d'avalanche augmente.

La forme générale des équipotentielles en présence d'une tension positive sur la grille G est schématisée par des lignes pointillées sur la figure 3. En présence d'un potentiel nul sur la grille G les lignes équipotentielles restent pratiquement parallèles à la courbure 20 et remontent à la superficie.

La grille G est reliée à la borne B par l'intermédiaire d'une résistance R non visible sur la coupe AA de la figure 3 mais visible sur la vue de dessus de la figure 4. Cette résistance peut être réalisée par une diffusion 24 de type N, peu dopée, dans le substrat de type P. Une métallisation 26 (figure 4) vient en contact dans une région 28 avec la grille G et dans une région 30 avec une extrémité de la diffusion 24. Une autre extrémité de la diffusion 24 est reliée par une zone de contact 32 à la métallisation 18, donc à la borne B. Les contacts 30 et 32 sont formés au dessus de petites régions 30' et 32' de type N+ diffusées aux extrémités de la résistance 24.

La capacité C du schéma de la figure 2 est simplement la capacité existante entre la grille G et le substrat P relié à la masse ainsi qu'entre la région 24 et le substrat; cette capacité peut facilement atteindre 0,1 picofarad du fait que la grille G n'est séparée du substrat que par une très faible épaisseur d'isolant (quelques centaines d'angströms au plus). Il n'est pas nécéssaire alors de rajouter une capacité spécifique pour aboutir au schéma de la figure 2.

La résistance R peut avoir une valeur de quelques kilohms.

Sur les figures 3 et 4, on a encore représenté une région superficielle 34 diffusée, de type N+, espacée latéralement de la diode D et reliée à la masse M par un prolongement de la metallisation 16.

On constitue ainsi, entre la cathode de la diode (région 12) le substrat 10, et la région 34 un transistor bipolaire latéral de type NPN. Ce transistor permet de maintenir un courant jusqu'a extinction totale de la surtension (et pas seulement jusqu'à ce que la tension redescende au dessous de seuil V1 d'avalanche).

## Revendications

1. Dispositif de protection de circuit intégré, comprenant une diode (D) connectée entre une borne (B) à protéger et une borne (M) de référence, caractérisé en ce qu'il comporte un moyen (G, R, C) pour modifier la répartition des lignes équipotentielles dans une région de déclenchement de la conduction en avalanche de la diode, ce moyen étant connecté à la borne à protéger et étant sensible à la pente de croissance des surtensions se présentant sur cette borne, de telle sorte que la tension de déclenchement d'avalanche soit plus faible lorsque la pente est plus forte et plus forte lorsque la pente est plus faible.

2. Dispositif selon la revendication 1 caractérisé en ce que le moyen pour modifier la répartition des équipotentielles comporte une grille isolée (G) entourant complètement la périphérie d'une région (12) diffusée dans un substrat semi-conducteur et reliée à la borne à protéger, la grille étant reliée à la borne à protéger, par l'intermédiaire d'un circuit intégrateur (R,C).

3. Dispositif selon la revendication 2 caractérisé en ce que la grille (G) est reliée à la borne à protéger (B) par une résistance (R) et est reliée à la borne de référence par une capacité (C).

4. Dispositif selon la revendication 3 caractérisé en ce que la capacité (C) est la capacité propre entre la grille et un substrat semi-conducteur (10) dont la grille est isolée par une couche isolante mince (22), le substrat étant relié à la borne de référence (M).

5. Dispositif selon l'une des revendications 3 et 4 caractérisé en ce que la résistance est une région (24) diffusée dans le substrat et de type de conductivité opposé au substrat.

## Claims

1. Protection device for an integrated circuit, comprising a diode (D) connected between a terminal (B) to be protected and a reference terminal (M), characterised in that it has a means (G, R, C) for modifying the distribution of the equipotential lines in a region of triggering the avalanche conduction of the diode, this means being connected to the terminal to be protected and being sensitive to the slope of increase in the over-voltages exhibited at this terminal, so that the avalanche triggering voltage is lower when the slope is greater and higher when the slope is lesser.

2. Device according to Claim 1, characterised in that the means for modifying the distribution of the equipotentials comprises an insulated gate (G) completely surrounding the periphery of a region (12) diffused in a semiconductor substrate and connected to the terminal to be protected, the gate being connected to the terminal to be protected by means of an integrating circuit (R, C).

3. Device according to Claim 2, characterised in that the gate (G) is connected to the terminal to be protected (B) through a resistance (R) and is connected to the reference terminal through a capacitance (C).

4. Device according to Claim 3, characterised in that the capacitance (C) is the inherent capacitance between the gate and a semiconductor substrate (10) whose gate is insulated by a thin insulating layer (22), the substrate being connected to the reference terminal (M).

5. Device according to one of Claims 3 and 4, characterised in that the resistance is a region (24) diffused in the substrate with a conductivity type opposite to the substrate.

## Patentansprüche

1. Schutzvorrichtung für einen integrierten Schaltkreis mit einer Diode (D), die zwischen eine zu schützenden Klemme (B) und eine Bezugsklemme (M) geschaltet ist, dadurch gekennzeichnet, daß sie ein Mittel (G, R, C) aufweist, um die Verteilung der Äquipotentiallinien in einer Zone der Auslösung der Lawinenleitung der Diode zu verändern, wobei dieses Mittel mit der zu schützenden Klemme verbunden und für die Steilheit der Überspannungen empfindlich ist, die an dieser Klemme auftreten, so daß die Lawinendurchbruchsspannung niedriger ist, wenn die Steilheit stärker ist, und höher, wenn die Steilheit geringer ist.

2. Vorrichtung nach Anspruch 1, dadurch gekennzeichnet, daß das Mittel zur Veränderung der Verteilung der Äquipotentiallinien ein isoliertes Gitter (G) aufweist, das die Peripherie einer Diffusionszone (12) in einem Halbleitersubstrat vollständig umgibt und mit der zu schützenden Klemme verbunden ist, wobei das Gitter mit der zu schützenden Klemme über einen Integrationskreis (R, C) verbunden ist.

3. Vorrichtung nach Anspruch 2, dadurch gekennzeichnet, daß das Gitter (G) mit der zu schützenden Klemme (B) über einen Widerstand (R) und mit der Bezugsklemme über eine Kapazität (C) verbunden ist.

4. Vorrichtung nach Anspruch 3, dadurch gekennzeichnet, daß die Kapazität (C) die Eigenkapazität zwischen dem Gitter und einem Halbleitersubstrat (10) ist, dessen Gitter durch eine dünne Isolierschicht (22) isoliert ist, wobei das Substrat mit der Bezugsklemme (M) verbunden ist.

5. Vorrichtung nach einem der Ansprüche 3 und 4, dadurch gekennzeichnet, daß der Widerstand eine Diffusionszone (24) im Substrat ist und eine dem Substrat entgegengesetzte Leitfähigkeit aufweist.
